# EUROPEAN PATENT SPECIFICATION

(11) **EP 0 333 838 B1**
(45) Date of publication and mention of the grant of the patent: **23.03.1994**
(21) Application number: 88909016.3
(22) Date of filing: 15.08.1988
(51) Int. Cl.: H01L 21/312, H01L 21/28, H01L 29/62, H01L 29/76

(54) **GaAs ELECTRICAL CIRCUIT DEVICES WITH LANGMUIR-BLODGETT INSULATOR LAYER**
GAAS-HALBLEITERSCHALTUNGSANORDNUNGEN MIT ISOLIERENDER LANGMUIR-BLODGETT-SCHICHT
DISPOSITIFS DE CIRCUITS ELECTRIQUES GaAs AVEC COUCHE ISOLANTE LANGMUIR-BLODGETT

(30) Priority: 09.10.1987 US 107082
(43) Date of publication of application: 27.09.1989
(73) Proprietor: Hughes Aircraft Company, Los Angeles, California 90045-0066 (US)
(72) Inventor: JOSEFOWICZ, Jack, Westlake Village, CA 91361 (US); RENSCH, David, B., Thousand Oaks, CA 91320 (US); RODOV, Vladimir, Redondo Beach, CA 90277 (US); BARTUR, Meir, Los Angeles, CA 90049 (US)
(74) Representative: KUHNEN, WACKER & PARTNER
(86) International application number: US8802758
(87) International publication number: WO8903588

(56) References cited:
- EP-A- 0 239 368
- EP-A- 0 244 835
- EP-A- 0 246 602
- WO-A-83/03165
- FR-A- 2 321 769
- PATENT ABSTRACTS OF JAPAN, volume 11, no. 254 (E-533)(2701), 18 August 1987 ; & JP-A-6265471
- JOURNAL OF PHYSICS, D : Applied Physics, volume 18, no. 12, December 1985, The Institute of Physics, (Bristol, GB), R.H. Tredgold et al. : "GaAs Schottky diodes incorporating Langmuir-Blodgett layers of pre-formed polymers", pages 2483-2487.
- THIN SOLID FILMS, volume 132, no. 1/4, October 1985, Elsevier Sequoia, printed in The Netherlands, (Lausanne, CH), C.D. Fung et al. : "Planar silicon field-effect transistors with Langmuir-Blodgett gate insulators", pages 33-39.

## Description

### Background of the invention

### Field of the invention

This invention relates to GaAs devices such as field effect transistors (FETs), and more particularly to metal-insulator-semiconductor field effect transistors (MIS-FETs), and to a method of forming a metal-insulator-semiconductor (MIS) type device on a gallium arsenide (GaAs) substrate.

### Description of the related art

A MIS type GaAs device in accordance with the preamble of claim 1, and a method of forming such a structure is for example known from Patents Abstracts of Japan, volume 11, no. 254 (E-533) (2701) & JP-A-62 65471. This MIS-type semiconductor element comprises a plurality of 20 layers of L-B films on a P-type GaAs substrate doped with Mg or the like. On the L-B films, an Al-electrode is formed by evaporation. On the backplane of the GaAs substrate, an ohmic electrode made by AuZn is formed. In addition to a MIS capacitor, a MISFET is also disclosed in said document.

From WO-A-83/03165 a process for the preparation of an ordered polymeric film on a substrate is known, which process comprises: (i) providing a reservoir of an amphiphilic preformed polymer; (ii) advancing the polymeric film receiving substrate into or onto the reservoir at least once; and (iii) recovering the substrate coated with the polymeric film. The polymeric film may be used for MIS devices as e.g. Schottky barrier MIS diodes, Schottky barrier MIS capacitors or FETs.

GaAs devices have been developed which offer considerably higher speed operation than other semi-conductor materials, for both discrete devices and digital integrated circuits. However, GaAs is a difficult material to work with because its surface is typically characterized by dangling bonds and surface defects which seriously limit the range of the gate voltage that can be applied to an FET. Present GaAs technology limits the positive gate voltage swing to between about 0 and 0.7 volts. This places severe noise margin limits of about 20 to 30 mV on these devices, and imposes rigid controls on circuit designs and processing.

Whereas other semiconductor materials such as silicon and indium phosphide can support metal-oxide-semiconductor FETs (MOSFETs), attempts to use GaAs with a deposited dielectric (e.g., SiO₂) as a gate insulator have resulted in large surface state and surface defects densities. This in turn "pins" the Fermi level to about 0.8 eV below the conduction band, such that it cannot be controlled by the gate voltage. To avoid this, the gate contact is made directly to the semiconductor substrate surface to form a Schottky junction, rather than forming a dielectric insulating layer between the gate contact and the channel as with silicon or InP. Unsuccessful attempts have been made for many years to locate or device a dielectric that can successfully passivate the surface states encountered with GaAs, and increase the gate barrier height beyond 0.7 volts. This problem is discussed in greater detail in S.D. Offsey et al., "Unpinned (100) GaAs Surfaces in Air Using Photochemistry," Applied Physics Letter 48 (7) pp.475 (Feb. 1986).

The attainment of larger gate voltage swings would greatly improve the prospects of being able to use GaAs in large complex digital integrated circuits. Another desired application for GaAs devices would be to use them in an inversion mode such as that employed by enhancement-type FETs, rather than the present limitation to a depletion/accumulation mode of operation. The present limitation in the Schottky gate barrier height (due to "pinning" of Fermi level) prevents GaAs devices from being operated in an inversion mode.

For silicon and InP devices in which gate insulators are commonly used, investigations have been reported concerning the use of Langmuir-Blodgett (L-B) films as the insulating medium. L-B films are formed from amphiphilic molecules with a hydrophobic "tail" and an ionizable "head", and are reported for example in an article by Hans Kuhn, "Functionalized Monolayer Assembly Manipulation," Thin Solid Films, 99, pp.1 (1983). A laboratory set-up was reported for the InP by G.G. Roberts, et al., Solid State & Electron Devices, "InP/Langmuir-film m.i.s.f.e.t.,", Vol. 2, No. 6, pp.169, Nov. 1978, In the described set-up, source and drain electrodes were evaporated onto an InP surface, with a gap between the source and drain defined by a tungsten wire stretched across the source-drain mask. An L-B film was substituted for SiO₂ as the gate insulator. The described fabrication process resulted in relatively large scale devices and was not applicable to small integrated circuit processing for microelectronics. A comparable laboratory approach to forming rudimentary silicon devices with L-B film substituted for the usual SiO₂ gate insulator was described in Lloyd, et al., "Amorphous Silicon/Langmuir-Blodgett Film Field Effect Transistor", Thin Solid Films, Vol. 99, pp.297 (1983). Neither of these reports, however, were suggested as being applicable to GaAs.

### SUMMARY OF THE INVENTION

In view of the problems previously encountered with GaAs devices, the purpose of the present invention is to provide a MIS type GaAs device, and in particular an FET device, in which the gate voltage is increased beyond 0.7 volts without the accompanying problems of an excessively high surface state density and a reduction in noise immunity.

The invention also seeks to produce a GaAs FET which is compatible with inversion mode operation and accompanying higher voltage swings, and to provide a fabrication method for GaAs devices which successfully meets all of these criteria and is compatible with IC processing.

These problems are solved by a MIS type GaAs device according to claim 1, and a method of forming such a device according to claim 10.

In accordance with the invention, an L-B layer is formed over a portion of a GaAs substrate, with a conductive contact overlying and contacting at least a portion of the L-B layer. The L-B layer can be fabricated as either a single film about 3 nm (30 angstroms) thick or as a composite of multiple L-B films each about 3 nm (30 angstroms) thick. These latter types of devices are capable of MOSFET-type inversion mode operation, with the L-B layer functioning as a gate insulator and also passivating dangling bond and surface defects in the GaAs.

In fabricating an FET, ohmic metal source and drain contacts are formed on either side of the channel are coated with a layer of metal, preferably nickel, having a hydrophilicity similar to that of the GaAs. The L-B layer is then formed as a continuous film over both the channel areas and the source and drain contacts, and a gate contact is thereafter made to the portion of the L-B layer over the channel region. The L-B material is then removed from the device except where it is covered by the gate contact. To avoid damaging the L-B layer, the gate contact is formed by depositing a succession of metal layers and cooling the device after each layer has been deposited.

Further features and advantages of the invention will be apparent to those skilled in the art from the following detailed description of preferred embodiments, taken together with the accompanying drawings, in which:

### DESCRIPTION OF THE DRAWINGS

FIGS. 1(a) - 1(e) are sectional views, not to scale, of successive steps in the fabrication of an FET in accordance with the invention with a single L-B gate film;
FIG. 2 is a sectional view, not to scale, of an FET with a multi-film L-B gate layer;
FIG. 3 is a sectional view, not to scale, of a diode constructed in accordance with the invention with a single L-B film layer; and
FIG. 4 is a capacitance-voltage graph for the diode shown in FIG. 3.

### DETAILED DESCRIPTION OF PREFERRED EMBODIMENTS

In contrast with prior GaAs devices which have conductive contacts in direct contact with the GaAs substrate via a reverse biased Schottky junction, the present invention interposes an insulative layer between the contact and the substrate. The layer is provided in the form of one or more L-B films, with the aggregate thickness of the films tailored to the intended use of the device.

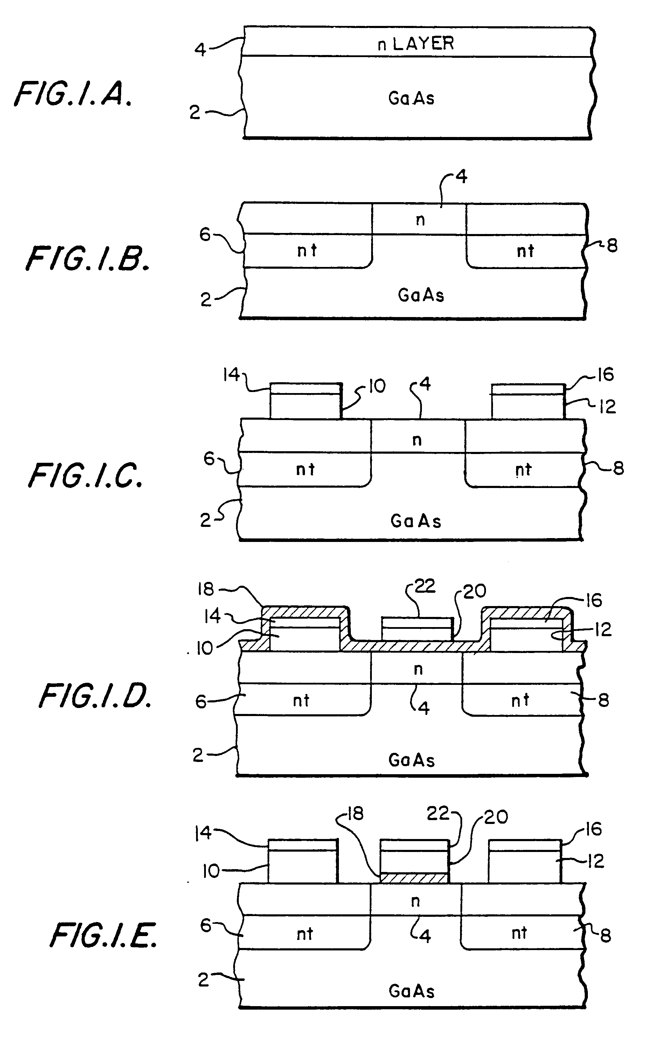

The preferred fabrication sequence for an FET with a single L-B gate insulating film is shown in FIGS. 1(a)-1(e). The resulting device is comparable to a MESFET (metal-semiconductor FET), but with a greater gate voltage swing than has previously been attainable. Since a partially insulating layer is placed between the gate contact and channel, the device is referred to as a metal-insulator FET (MISFET).

Referring to FIG. 1(a), a GaAs substrate 2 is shown which includes an n-type silicon channel implant 4. Alternately, boron could be implanted to produce a p-type channel, or other n or p dopants may be implanted. Molecular beam epitaxy or chemical vapor deposition could also be employed to establish the doped channel region 4. The wafer is annealed after the doped layer 4 is formed.

N⁺ regions 6 and 8 are then implanted into the substrate to provide source and drain regions, respectively, as illustrated in FIG. 1(b). After another anneal, ohmic metal contact pads or bodies 10 and 12 are deposited respectively over the source and drain implants 6 and 8, and annealed (FIG. 1(c)). Contact pads 10 and 12 are typically formed from gold. However, it has been found that L-B films tend to develop discontinuities and to break up when deposited over heterogeneous materials such as gold and GaAs. Accordingly, the contact pads 10 and 12 are capped by the deposition of respective layers of metal 14, 16 having a hydrophobicity sufficiently similar to the GaAs surface to permit the formation of a continuous L-B layer in a subsequent step. Nickel is a suitable cap material. Other Group VIII metals with the same valence as nickel, such as platinum and palladium, might also be suitable.

A continuous L-B layer 18 is next deposited over the device by a dipped coating method that is consistent with semiconductor clean room practices, as shown in FIG. 1(d). The L-B layer 18 consists of a single film, which with present fabrication techniques is about 3 nm (30 angstroms) thick. The invention has been demonstrated using ω-tricosenoic acid L-B film but, as discussed below, other L-B formulations may be more desirable in various circumstances.

The L-B layer 18 forms a continuous film over both the ohmic contacts 10 and 12 and the intervening channel portion of the n- implant 4. If a blanket implant was initially employed, the substrate is preferably treated with an O₂ implant before laying down the L-B film to isolate the channels; the O₂ is not needed if isolated channel implants are employed.

Still referring to FIG. 1(d), a gate contact 20 is next formed over the portion of the L-B layer in alignment with the channel from aluminum or other suitable metal. The gate contact is preferably established by evaporating a film of the contact metal over the entire wafer, followed by the evaporation of a nickel cap 22 over the gate contact portion of the evaporated aluminum. The nickel cap acts as a mask, permitting the aluminum to be etched away except under the cap. The aluminum layer is preferably about 100 nm (1,000 angstroms) thick. To avoid damaging the underlying L-B layer from the heat associated with the aluminum evaporation, five successive evaporations of auminum are preferably performed, each about 20 nm (200 angstroms) thick. The wafer is permitted to cool after each layer is formed while the evaporator is turned off. Alternately, a low temperature evaporation process can be employed. One disadvantage of aluminum, is a tendency to oxidize. Other metals could be substituted for the gate contact, with an L-B layer that could withstand higher temperatures than those associated with aluminum evaporation.

In the final step of fabrication, illustrated in FIG. 1(e), the exposed L-B layer is removed, preferably with an O₂ plasma, leaving only the portion of the L-B layer below the gate contact 20. The gate contact itself is typically about 2 µm wide, while the source and drain contacts 10, 12 are typically separated by about 5 µm. In a particular implementation the n-channel implant was implanted with Si²⁸ at a density of 5 x 10¹²/cm² and an implant energy of 70 keV to form a depletion mode device. Its transconductance was determined to be about 15 mS/mm, and there was no indication of gate leakage current with a gate bias of 2 volts. By contrast, a similar aluminum gate MESFET without the L-B layer was found to have a transconductance of about 23 mS/mm, and gate leakage current resulted from gate biases in excess of 0.8 volts.

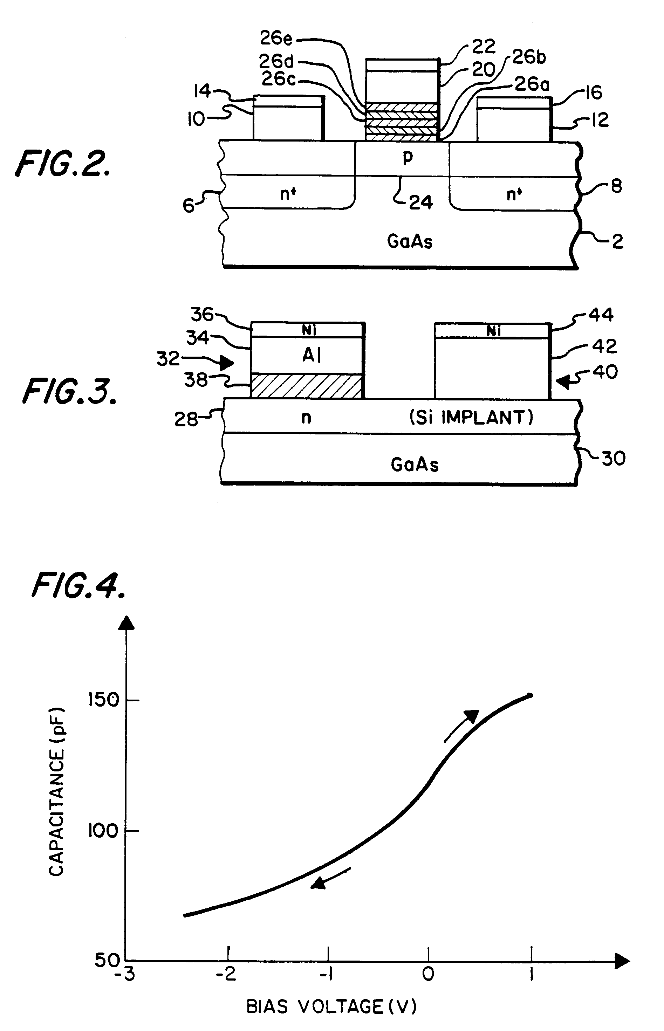

A similar FET employing the techniques of the invention is shown in FIG. 2, in which elements which are the same as in FIGS. 1(a) - 1(e) are identified by the same reference numerals. The device shown in FIG. 2 is capable of "inversion mode" operation. This is the type of operation obtained with an MOSFET, in which the gate contact is separated from the channel by an insulating oxide layer. For a p-channel MOSFET, the source and drain are doped n while the channel is doped p. A positive gate voltage attracts electrons into the channel area adjacent the insulator layer, thereby permitting conduction between the source and drain. In the device of FIG. 2, the channel 24 is doped p. A plural succession of L-B layers 26a, b, c, d and e separate the gate contact 20 from the channel 24. The device is fabricated in a manner similar to that illustrated in FIGS. 1(a) - 1(e), but 5 L-B films are laid down in succession to provide a thicker L-B composite layer. A different number of L-B films could be used, but with each films 3 nm (30 angstroms) thick. Thus, the composite L-B layer insulates the gate contact 20 from the underlying channel 24.

It has also been discovered that the L-B material provides the distinct advantage of passivating dangling bonds and surface defects in the underlying GaAs channel. As noted previously, dangling bonds and surface defects have been a long standing problem that had prevented the fabrication of MISFET-type devices with GaAs. The solution of this problem with the present invention opens up an entire new area of circuit design. By lowering the surface state density of the GaAs such that its surface is not "pinned" at 0.8 eV below the conduction band, voltage swings in the 1-4 volt range can be tolerated. One result of this improvement is the ability to offer better device performance for digital signal processing, thereby allowing VLSI circuits to be produced due to improved noise immunity and larger achievable gate voltage.

L-B films are currently under investigation, and the exact mechanism by which the GaAs dangling bonds and surface defects are passivated is still a matter of some speculation. However, it is currently felt that the ionized "head" of the L-B molecules attaches to the surface of the GaAs to passivate it. The type of head group present in the L-B film is currently felt to be an important aspect in the degree of passivation attained, and also in increasing the gate voltage threshold. The GaAs surface quality is highly dependent upon the particular type of fabrication procedure employed, and varies with factors such as etching, polishing, chemical treatment and the degree of oxidation employed. Accordingly, although to date the invention has been demonstrated only with ω-tricosenoic acid L-B films, it is felt that even better performance may be obtainable with the other L-B types. It is also believed that some L-B films may work better with certain GaAs surfaces and other types of L-B films may work better with other GaAs surfaces, and that the particular choice of L-B film will ultimately be selected to optimize the performance characteristics for the particular GaAs surface under consideration.

A capacitance-voltage trace for the diode with a single L-B film is shown in FIG. 4. This exhibits the characteristic shape of an MIS (metal-insulator-semi-conductor) capacitor with a transition from accumulation to depletion. The flat band voltage which occurs in the vicinity of zero volts implies a lowering of interface states or unpinning of the GaAs surface.

A novel type of semiconductor device has thus been shown and described which combines the fast response of GaAs with the advantage of gate insulation that have heretofore been unobtainable with GaAs. Specific types of devices have been shown, but it should be understood that the invention is applicable in general to GaAs devices in which an insulating or barrier layer is desirable between a contact and the substrate. For example, the described technique is also compatible with the fabrication of self-aligned substantial gate MISFETs.

## Claims

1. A metal-insulator-semiconductor (MIS) type GaAs device, comprising
a GaAs substrate (2),
a Langmuir-Blodgett (L-B) layer (18; 26a, 26b, 26c, 26d, 26e) overlying and in contact with a portion of the substrate (2),
a conductive contact (20) overlying and contacting at least a portion of the L-B layer (18; 26a, 26b, 26c, 26d, 26e), and separated thereby from the substrate (2), and
at least one ohmic metal body (10, 12) contacting the substrate (2) lateral to the conductive contact (20), **characterized** by
a layer of metal (14, 16) having a hydrophobicity similar to that of the GaAs substrate (2) on the ohmic metal body (10, 12).

2. The device of claim 1, the L-B layer comprising a single L-B film (18).

3. The device of claim 1, the L-B layer comprising a composite of a plurality of L-B films (26a, 26b, 26c, 26d, 26e).

4. The device of one of the previous claims, wherein said metal layer (14, 16) consists of nickel.

5. The device of one of the previous claims, further comprising means for applying a voltage differential across the L-B layer (18; 26a, 26b; 26c; 26d; 26e) and the GaAs substrate (2).

6. The device of one of the previous claims, forming a metal-insulator-semiconductor field effect transistor (MISFET) comprising:
spaced source and drain regions (6, 8) in the substrate (2),
a channel region (4; 24) in the substrate (2) between the source and drain regions (6, 8), wherein said Langmuir-Blodgett (L-B) layer (18; 26a, 26b, 26c, 26d, 26e) overlies the channel region (4; 24), and is thin enough to permit tunneling therethrough to the channel region (4, 24) in response to an applied voltage,
electrical contacts (10, 12, 14, 16) respectively on the source and drain regions (6, 8), and a conductive contact on the L-B layer over the channel region.

7. The device of claim 6, said L-B layer or each of said L-B layers being approximately 3 nm (30 angstroms) thick.

8. The device of claim 6 or 7, wherein the electrical contacts for the source and drain (6, 8) each comprise said ohmic metal body (10, 12) with said layer of metal (14, 16) having a hydrophilicity similar to that of the GaAs substrate (2) over the ohmic metal body (10, 12).

9. The device of claims 6, 7 or 8, wherein the L-B layer (18; 26a, 26b, 26c, 26d, 26e) is thick enough to insulate the channel region (4; 24) and at least partially passivating the substrate surface.

10. A method of forming a metal-insulator-semiconductor (MIS) type GaAs device comprising:
forming at least one ohmic metal body (10, 12) on the substrate (2) lateral to a conductive contact area prior to forming said contact (20),
forming a layer of metal (14, 16) over each of said bodies (10, 12), said metal layers (14, 16) having a hydrophobicity similar to that of the GaAs substrate (2), forming a Langmuir-Blodgett (L-B) layer (18; 26a, 26b, 26c, 26d, 26e) as a substantially continuous layer over a portion of the substrate (2) including said conductive contact area, and over each ohmic metal body (10, 12) prior to forming said conductive contact (20), and
removing said L-B layer (18; 26a, 26b, 26c, 26d, 26e) from the areas not under said conductive contact (20) after forming said contact.

11. The method of claim 10, wherein said L-B layer is formed as single film (18).

12. The method of claim 10, wherein said L-B layer is formed as a composite of a plurality of L-B films (26a, 26b, 26c, 26d, 26e).

13. The method of one of the claims 10-12, wherein the thickness of said L-B layer or each of said L-B layers is approximately 3 nm (30 angstroms).

14. The method of one of claims 10-13, wherein said conductive contact (20) is formed by placing a layer of conductive contact material over said continuous L-B layer (18; 26a, 26b, 26c, 26d, 26e), masking a portion of the conductive contact material with another conductive material (22), and removing the unmasked portion of the conductive contact material to expose the underlying L-B layer for removal.

## Patentansprüche

1. GaAs-Vorrichtung vom Metall-Isolator-Halbleiter(MIS)-Typ, welche aufweist:
ein GaAs-Substrat (2),
eine Langmuir-Blodgett(L-B)-Schicht (18; 26a, 26b, 26c, 26d, 26e), welche sich über und in Kontakt mit einem Abschnitt des Substrats (2) befindet,
einen leitfähigen Kontakt (20), welcher sich über und in Kontakt mit zumindest einem Abschnitt der L-B-Schicht (18; 26a, 26b, 26c, 26d, 26e) befindet und hierdurch von dem Substrat (2) getrennt ist, und
mindestens einen ohmschen Metallkörper (10, 12), welcher seitlich zu dem leitfähigen Kontakt (20) mit dem Substrat (2) in Kontakt steht,
gekennzeichnet durch
eine Metallschicht (14, 16) auf dem ohmschen Metallkörper (10, 12), welche eine Hydrophobie ähnlich derjenigen des GaAs-Substrats aufweist.

2. Vorrichtung nach Anspruch 1, wobei die L-B-Schicht einen einzigen L-B-Film (18) aufweist.

3. Vorrichtung nach Anspruch 1, wobei die L-B-Schicht einen Verbund aus einer Mehrzahl von L-B-Filmen (26a, 26b, 26c, 26d, 26e) aufweist.

4. Vorrichtung nach einem der vorangegangenen Ansprüche, wobei die Metallschicht (14, 16) aus Nickel besteht.

5. Vorrichtung nach einem der vorangegangenen Ansprüche, welche des weiteren ein Mittel zum Anlegen eines Spannungsdifferentials über die L-B-Schicht (18; 26a, 26b, 26c, 26d, 26e) und das GaAs-Substrat (2) aufweist.

6. Vorrichtung nach einem der vorangegangenen Ansprüche, welche einen Metall-Isolator-Halbleiterfeldeffekttransistor (MISFET) bildet und aufweist:
voneinander beabstandete Source- und Drain-Bereiche (6, 8) in dem Substrat (2),
einen Kanalbereich (4; 24) in dem Substrat (2) zwischen dem Source- und dem Drain-Bereich (6, 8), worin die Langmuir-Blodgett(L-B)-Schicht (18; 26a, 26b, 26c, 26d, 26e) über dem Kanalbereich (4; 24) liegt und dünn genug ist, um ein Tunneln durch sie hindurch zum Kanalbereich (4, 24) als Antwort auf eine angelegte Spannung zu erlauben,
elektrische Kontakte (10, 12, 14, 16) auf dem Source- bzw. Drainbereich (6, 8), und einen leitfähigen Kontakt auf der L-B-Schicht über dem Kanalbereich.

7. Vorrichtung nach Anspruch 6, wobei die L-B-Schicht oder jede der L-B-Schichten etwa 3 nm (30 Å) dick ist.

8. Vorrichtung nach Anspruch 6 oder 7, wobei die elektrischen Kontakte für Source und Drain (6, 8) jeweils den ohmschen Metallkörper (10, 12) mit der Metallschicht (14, 16) aufweisen, welche eine Hydrophilie ähnlich derjenigen des GaAs-Substrats (2) über dem ohmschen Metallkörper (10, 12) aufweist.

9. Vorrichtung nach Anspruch 6, 7 oder 8, wobei die L-B-Schicht (18; 26a, 26b, 26c, 26d, 26e) dick genug ist, um den Kanalbereich (4; 24) zu isolieren und die Substratoberfläche zumindest teilweise zu passivieren.

10. Verfahren zur Herstellung einer GaAs-Vorrichtung vom Metall-Isolator-Halbleiter(MIS)-Typ, welches die Schritte aufweist:
Bilden zumindest eines ohmschen Metallkörpers (10, 12) seitlich zu einem leitfähigen Kontaktbereich vor der Bildung des Kontakts (20),
Bilden einer Metallschicht (14, 16) über jedem dieser Körper (10, 12), wobei die Metallschichten (14, 16) eine Hydrophobie ähnlich derjenigen des GaAs-Substrats (2) aufweisen,
Bilden einer Langmuir-Blodgett(L-B)-Schicht (18; 26a, 26b, 26c, 26d, 26e) als im wesentliche kontinuierliche Schicht über einem Abschnitt des Substrats (2), welcher den leitfähigen Kontaktbereich umfaßt, sowie über jedem ohmschen Metallkörper (10, 12) vor der Bildung des leitfähigen Kontakts (20), und
Entfernen der L-B-Schicht (18; 26a, 26b, 26c, 26d, 26e) von den Bereichen, welche sich nach der Bildung des Kontakts nicht unter dem leitfähigen Kontakt (20) befinden.

11. Verfahren nach Anspruch 10, wobei die L-B-Schicht als einziger Film (18) gebildet wird.

12. Verfahren nach Anspruch 10, wobei die L-B-Schicht als Verbund aus einer Mehrzahl von L-B-Filmen (26a, 26b, 26c, 26d, 26e) gebildet wird.

13. Verfahren nach einem der Ansprüche 10 - 12, wobei die Dicke der L-B-Schicht oder jeder der L-B-Schichten etwa 3 nm (30 Å) beträgt.

14. Verfahren nach einem der Ansprüche 10 - 13, wobei der leitfähige Kontakt (20) gebildet wird durch Aufbringen einer Schicht von leitfähigem Kontaktmaterial über die kontinuierliche L-B-Schicht (18; 26a, 26b, 26c, 26d, 26e), Maskieren eines Abschnitts des leitfähigen Kontaktmaterials mit einem weiteren leitfähigen Material (22), und Entfernen des unmaskierten Abschnitts des leitfähigen Kontaktmaterials, um die darunterliegende L-B-Schicht zum Entfernen freizulegen.

## Revendications

1. Dispositif à GaAs du type à métal-isolant-semiconducteur (MIS), comportant :
un substrat (2) en GaAs ;
une couche de Langmuir-Blodgett (L-B) (18 ; 26a, 26b, 26c, 26d, 26e) recouvrant une partie du substrat (2) et en contact avec elle,
un contact conducteur (20) recouvrant au moins une partie de la couche (L-B) (18 ; 26a, 26b, 26c, 26d, 26e) et en contact avec elle, et séparé par celle-ci du substrat (2), et
au moins un corps métallique ohmique (10, 12) en contact avec le substrat (2) latéralement au contact conducteur (20),
caractérisé par
une couche de métal (14, 16) ayant une hydrophilie similaire à celle du substrat (2) en GaAs sur le corps métallique ohmique (10, 12).

2. Dispositif selon la revendication 1, dans lequel la couche L-B comprend un film L-B unique (18).

3. Dispositif selon la revendication 1, dans lequel la couche L-B comprend un composite de plusieurs films L-B (26a, 26b, 26c, 26d, 26e).

4. Dispositif selon l'une des revendications précédentes, dans lequel ladite couche métallique (14, 16) est constituée de nickel.

5. Dispositif selon l'une des revendications précédentes, comportant en outre des moyens pour appliquer une tension différentielle à travers la couche L-B (18 ; 26a; 26b ; 26c ; 26d ; 26e) et le susbstrat (2) en GaAs.

6. Dispositif selon l'une des revendications précédentes, formant un transistor à effet de champ à métal-isolant-semiconducteur (MISFET), comportant :
des régions espacées de source et de drain (6, 8) dans le substrat (2),
une région de canal (4; 24) dans le substrat (2) entre les régions de source et de drain (6, 8), ladite couche de Langmuir-Blodgett (L-B) (18 ; 26a, 26b, 26c, 26d, 26e) recouvrant la région de canal (4 ; 24) et étant assez mince pour permettre un effet de tunnel à travers elle, vers la région de canal (4, 24) en réponse à une tension appliquée,
les contacts électriques (10, 12, 14, 16) respectivement sur les régions de source et de drain (6, 8), et un contact conducteur sur la couche L-B au-dessus de la région de canal.

7. Dispositif selon la revendication 6, dans lequel ladite couche L-B ou chacune desdites couches L-B a une épaisseur d'environ 3 nm (30 angströms).

8. Dispositif selon la revendication 6 ou 7, dans lequel les contacts électriques pour la source et le drain (6, 8) comprennent chacun ledit corps métallique ohmique (10, 12), ladite couche de métal (14, 16) ayant une hydrophilie similaire à celle du substrat (2) en GaAs au-dessus du corps métallique ohmique (10, 12).

9. Dispositif selon les revendications 6, 7 ou 8, dans lequel la couche L-B (18 ; 26a, 26b, 26c, 26d, 26e) est assez épaisse pour isoler la région de canal (4 ; 24) et passivant au moins partiellement la surface du substrat.

10. Procédé de formation d'un dispositif à GaAs du type métal-isolant-semiconducteur (MIS), consistant :
à former au moins un corps métallique ohmique (10, 12) sur le substrat (2) latéralement en une zone de contact conducteur avant de former ledit contact (20),
à former une couche de métal (14, 16) sur chacun desdits corps (10, 12), lesdites couches de métal (14, 16) ayant une hydrophilie similaire à celle du substrat (2) au GaAs,
à former une couche de Langmuir-Blodgett (L-B) (18 ; 26a, 26b, 26c, 26d, 26e) en tant que couche sensiblement continue sur une partie du substrat (2) comprenant ladit zone conductrice de contact et au-dessus de chaque corps métallique ohmique (10, 12) avant de former ledit contact conducteur (20), et
à éliminer ladite couche L-B (18 ; 26a, 26b, 26c, 26d, 26e) des zones qui ne sont pas au-dessous dudit contact conducteur (20) après la formation dudit contact.

11. Procédé selon la revendication 10, dans lequel ladite couche L-B est formée en un film unique (18).

12. Procédé selon la revendication 10, dans lequel la couche L-B est formée en un composite de plusieurs films L-B (26a, 26b, 26c, 26d, 26e).

13. Procédé selon l'une des revendications 10-12, dans lequel l'épaisseur de ladite couche L-B ou de chacune desdites couches L-B est d'environ 3 nm (30 angströms).

14. Procédé selon l'une des revendications 10-13, dans lequel ledit contact conducteur (20) est formé par mise en place d'une couche d'une matière de contact conductrice sur ladite couche L-B continue (18 ; 26a, 26b, 26c, 26d, 26e), masquage d'une partie de la matière de contact conductrice avec une autre matière conductrice (22) et élimination de la partie non masquée de la matière de contact conductrice pour mettre à nu la couche L-B sous-jacente à éliminer.
